# EUROPÄISCHE PATENTSCHRIFT

(11) **EP 1 741 137 B1**
(45) Veröffentlichungstag und Bekanntmachung des Hinweises auf die Patenterteilung: **25.06.2008**
(21) Anmeldenummer: 05731920.4
(22) Anmeldetag: 13.04.2005
(51) Int. Cl.: H01L 23/373, C22C 26/00

(54) **WÄRMESENKE AUS BORHALTIGEM DIAMANT-KUPFER-VERBUNDWERKSTOFF**
HEAT SINK MADE FROM A DIAMOND/COPPER COMPOSITE MATERIAL CONTAINING BORON
DISSIPATEUR THERMIQUE CONSTITUE D'UN MATERIAU COMPOSITE DIAMANT-CUIVRE RENFERMANT DU BORE

(30) Priorität: 29.04.2004 AT 3242004
(43) Veröffentlichungstag der Anmeldung: 10.01.2007
(73) Patentinhaber: PLANSEE SE, 6600 Reutte (AT); Ecole Polytechnique Fédérale de Lausanne (EPFL), 1015 Lausanne (CH)
(72) Erfinder: WEBER, Ludger, CH-1052 Le Mont sur Lausanne (CH)
(86) Internationale Anmeldenummer: PCT/AT2005/000126
(87) Internationale Veröffentlichungsnummer: WO 2005/106952

(56) Entgegenhaltungen:
- EP-A- 0 364 155
- EP-A- 0 475 575
- EP-A- 0 898 310
- US-A- 5 783 316
- US-A1- 2004 070 071

## Beschreibung

Die Erfindung betrifft ein Bauteil als Wärmesenke aus einem Verbundwerkstoff mit 40 bis 90 Vol.% Diamantkörnern und 7 bis 59 Vol.% Kupfer oder einem kupferreichen Mischkristall mit Cu > 80 At.% und ein Verfahren zu dessen Herstellung.

Eine breite Anwendung finden Wärmesenken bei der Herstellung von elektronischen Komponenten. Neben der Wärmesenke sind die Halbleiterkomponente und eine mechanisch stabile Umhüllung die wesentlichen Bestandteile eines elektronischen Package. Für die Wärmesenke werden auch des Öfteren die Bezeichnungen Substrat, Wärmespreizer oder Trägerplatte verwendet. Die Halbleiterkomponente besteht beispielsweise aus einkristallinem Silizium oder Galliumarsenid. Diese ist mit der Wärmesenke verbunden, wobei als Fügetechnik üblicherweise Lötverfahren zum Einsatz kommen. Die Wärmesenke hat die Funktion, die beim Betrieb der Halbleiterkomponente entstehende Wärme abzuleiten. Halbleiterkomponenten mit besonders hoher Wärmeentwicklung sind beispielsweise LDMOS (laterally diffused metal oxide semi-conductor), Laserdioden, CPU (central processing unit), MPU (microprocessor unit) oder HFAD (high frequency amplifying device).
Die geometrischen Ausführungen der Wärmesenke sind anwendungsspezifisch und vielfältig. Einfache Formen sind flache Plättchen. Es werden jedoch auch komplex gestaltete Substrate mit Ausnehmungen und Stufen eingesetzt. Die Wärmesenke selbst wiederum ist mit einer mechanisch stabilen Umhüllung verbunden.
Die Wärmeausdehnungskoeffizienten der zum Einsatz kommenden Halbleiterwerkstoffe sind im Vergleich zu anderen Werkstoffen niedrig und werden in der Literatur für Silizium mit 2,1 x 10⁻⁶ K⁻¹ bis 4,1 x 10⁻⁶ K⁻¹ und für Galliumarsenid mit 5, 6 x 10⁻⁶ K⁻¹ bis 5,8 x 10⁻⁶ K⁻¹ angegeben.
Auch andere Halbleiterwerkstoffe, die großtechnisch noch nicht breit eingesetzt werden, wie z.B. Ge, InP oder Siliziumkarbid weisen ähnlich niedere Ausdehnungskoeffizienten auf. Für die Umhüllung werden üblicherweise keramische Werkstoffe, Werkstoffverbunde oder auch Kunststoffe eingesetzt.

Beispiele für keramische Werkstoffe sind Al₂O₃ mit einem Ausdehnungskoeffizienten von 6,5 x 10⁻⁶ K⁻¹ oder Aluminiumnitrid mit einem Ausdehnungskoeffizienten von 4,5 x 10⁻⁶ K⁻¹.

Ist das Ausdehnungsverhalten der beteiligten Komponenten unterschiedlich, werden Spannungen im Verbund eingebaut, die zu Verwerfungen, zu Ablösungen oder zum Bruch der Komponenten führen können. Spannungen können dabei bereits bei der Herstellung des Package entstehen und zwar während der Abkühlphase von der Löttemperatur auf Raumtemperatur. Jedoch auch beim Betrieb des Package treten Temperaturschwankungen auf, die beispielsweise von -50°C bis 200°C reichen und zu thermomechanischen Spannungen im Package führen können.
Daraus ergeben sich die Anforderungen an den Werkstoff für die Wärmesenke. Zum einen soll er eine möglichst hohe Wärmeleitfähigkeit aufweisen, um den Temperaturanstieg der Halbleiterkomponente während des Betriebes möglichst gering zu halten. Zum anderen ist es erforderlich, dass der Wärmeausdehnungskoeffizient möglichst gut sowohl an den der Halbleiterkomponente, als auch an den der Hülle angepasst ist. Einphasige metallische Werkstoffe erfüllen das geforderte Eigenschaftsprofil nicht ausreichend, da die Werkstoffe mit hoher Wärmeleitfähigkeit auch einen hohen Wärmeausdehnungskoeffizienten besitzen.
Daher werden, um dem Anforderungsprofil gerecht zu werden, für die Herstellung des Substrates Verbundwerkstoffe oder Werkstoffverbunde eingesetzt.
Übliche Wolfram-Kupfer und Molybdän-Kupfer Verbundwerkstoffe oder Werkstoffverbunde wie diese beispielsweise in der EP 0 100 232, US 4 950 554 und der US 5 493 153 beschrieben sind, weisen eine thermische Leitfähigkeit bei Raumtemperatur von 170 bis 250 W/(m.K) bei einem Wärmeausdehnungskoeffizienten von 6,5 x 10⁻⁶ bis 9,0 x 10⁻⁶ K⁻¹ auf, was für viele Anwendungen nicht mehr ausreichend ist.

Mit den steigenden Anforderungen an die thermische Leitfähigkeit von Wärmesenken fanden auch Diamant bzw. diamanthaltige Verbundwerkstoffe oder Werkstoffverbunde Interesse. So liegt die Wärmeleitfähigkeit von Diamant bei 1.400 bis 2.400 W/(m.K), wobei speziell der Gehalt an Stickstoff- und Boratomen auf Gitterplätzen qualitätsbestimmend ist.

In der EP 0 521 405 ist eine Wärmesenke beschrieben, die auf der dem Halbleiterchip zugewandten Seite eine polykristalline Diamantschicht aufweist. Mittels CVD hergestellte Diamantschichten weisen eine Wärmeleitfähigkeit von 1000 bis 1500 W/(m.K) auf. Durch das Fehlen einer plastischen Verformbarkeit der Diamantschicht kann es jedoch bereits beim Abkühlen von der Beschichtungstemperatur zu Rissen in der Diamantschicht kommen.

Die US 5 273 790 beschreibt einen Diamantverbundwerkstoff mit einer thermischen Leitfähigkeit > 1.700 W/(m.K), bei dem lose, in Form gebrachte Diamantteilchen mittels nachfolgender Diamantabscheidung aus der Gasphase in einen stabilen Formkörper übergeführt werden. Der so gefertigte Diamantverbund ist für die kommerzielle Anwendung in Massenteilen zu teuer.

In der WO 99/12866 ist ein Verfahren zur Herstellung eines Diamant-Siliziumkarbid-Verbundwerkstoffes beschrieben. Die Herstellung erfolgt durch Infiltration eines Diamantskelettes mit Silizium oder einer Siliziumlegierung. Aufgrund des hohen Schmelzpunktes von Silizium und der dadurch bedingten hohen Infiltrationstemperatur wird Diamant teilweise in Kohlenstoff bzw. in weiterer Folge in Siliziumkarbid umgewandelt. Auf Grund der hohen Sprödigkeit ist die mechanische Bearbeitbarkeit dieses Werkstoffes höchst problematisch und aufwendig.

Die US 4 902 652 beschreibt ein Verfahren zur Herstellung eines gesinterten Diamantwerkstoffes. Auf Diamantpulver wird dabei mittels physikalischer Beschichtungsverfahren ein Element aus der Gruppe Übergangsmetalle der Gruppen 4a, 5a und 6a, Bor und Silizium abgeschieden. Anschließend werden die beschichteten Diamantkörner mittels eines Festphasensinterprozesses bei hohem Druck miteinander verbunden. Nachteilig ist, dass das entstehende Produkt eine hohe Porosität aufweist. Zudem ist der Herstellprozess sehr aufwendig.

Die US 5 045 972 beschreibt einen Verbundwerkstoff, in dem neben Diamantkörnern mit einer Größe von 1 bis 50 µm eine metallische Matrix vorliegt, die aus Aluminium, Magnesium, Kupfer, Silber oder deren Legierungen besteht. Nachteilig dabei ist, dass die metallische Matrix nur mangelhaft an den Diamantkörnern angebunden ist, so dass dadurch die Wärmeleitfähigkeit und mechanische Integrität in nicht ausreichendem Maße gegeben ist.
Auch die Verwendung von feinerem Diamantpulver, beispielsweise mit einer Korngröße < 3 µm, wie dies aus der US 5 008 737 hervorgeht, verbessert die Diamant / Metall Haftung nicht und führt auf Grund der größeren Interfacefläche Diamant / Metall zur einer deutlichen Verschlechterung der Wärmeleitfähigkeit. Die US 5 783 316 beschreibt ein Verfahren, bei dem Diamantkörner mit W, Zr, Re, Cr oder Titan beschichtet, die beschichteten Körner in weiter Folge kompaktiert werden und der poröse Körper z.B. mit Cu, Ag oder Cu-Ag Schmelzen infiltriert wird. Die hohen Beschichtungskosten begrenzen das Einsatzgebiet derartig hergestellter Verbundwerkstoffe.
Die EP 0 859 408 beschreibt einen Werkstoff für Wärmesenken, dessen Matrix aus Diamantkörnern und Metallkarbiden gebildet ist, wobei die Zwischenräume der Matrix durch ein Metall gefüllt sind. Als Metallkarbide werden die Karbide der Metalle der 4a bis 6a Gruppen des Periodensystems bezeichnet. Besonders hervorgehoben werden dabei in der EP 0 859 408 TiC, ZrC und HfC. Als besonders vorteilhafte Füllmetalle sind Ag, Cu, Au und Al angeführt. Die Übergangsmetalle der Gruppen 4a bis 6a sind allesamt starke Karbidbildner. Die entstehenden Karbidschichten sind deshalb relativ dick. Dies in Verbindung mit der geringen Wärmeleitfähigkeit dieser Karbide (10 - 65 W/mK) senkt die wärmeleitfähigkeitssteigernde Wirkung der Diamantphase stark ab.
Infiltriert man ein Diamantskelett mit einer Legierung, die einen starken Karbidbildner enthält, kommt es zur übermäßigen Karbidbildung in den randnahen Bereichen, wodurch das Infiltrationsgut an Karbidbildner verarmt und im Inneren keine genügende Anbindung des Metalles an den Diamanten mehr vorhanden ist. Dies führt zum einen zu Werkstoffinhomogenitäten, zum anderen wird auch der Infiltrationsprozess durch die Abnahme der offenen Porosität negativ beeinflusst.

Eine Erhöhung der Konzentration karbidbildender Elemente vermag zwar die Verarmung abzuschwächen und somit die Anbindung im Inneren zu verbessern, zugleich birgt sie aber auch die Gefahr, dass Reste des Karbidbildners aus kinetischen Gründen in fester Lösung bleiben und dass dadurch die thermische Leitfähigkeit der Metallphase stark verschlechtert wird.

Die EP 0 898 310 beschreibt eine Wärmesenke, die aus Diamantkörnern, einem Metall oder einer Metalllegierung hoher Wärmeleitfähigkeit aus der Gruppe Cu, Ag, Au, Al, Mg und Zn und einem Metallkarbid der Metalle der Gruppen 4a, 5a und Cr besteht, wobei die Metallkarbide zu zumindest 25 % die Oberfläche der Diamantkörner bedecken. Auch hier wirken sich die schlechte Wärmeleitfähigkeit der Karbide der 4a, 5a Gruppen des Periodensystems und Cr, die hohe Affinität dieser Elemente mit Kohlenstoff und die zum Teil nicht vernachlässigbare Löslichkeit in Cu, Ag, Au, Al und Mg nachteilig aus.

In den letzten Jahren sind die Prozessgeschwindigkeit und der Integrationsgrad der Halbleiterkomponenten stark angestiegen, was auch zu einer Zunahme der Wärmeentwicklung im Package geführt hat. Ein optimales Wärmemanagement stellt daher ein immer wesentlicheres Kriterium dar. Die Wärmeleitfähigkeit der oben beschriebenen Werkstoffe reicht für eine Vielzahl von Anwendungen nicht mehr aus, bzw. ist deren Herstellung für eine breite Verwendung zu aufwendig. Die Verfügbarkeit von verbesserten, kostengünstigen Wärmesenken stellt eine Voraussetzung für eine weitere Optimierung von Halbleiterbauelementen dar. Aufgabe der vorliegenden Erfindung ist somit, für ein als Wärmesenke vorgesehenes Bauteil einen Verbundwerkstoff bereitzustellen, der eine hohe Wärmeleitfähigkeit und einen niedrigen Ausdehnungskoeffizienten aufweist, bei Verarbeitungseigenschaften, die eine kostengünstige Herstellung ermöglichen. Gelöst wird diese Aufgabe durch ein Bauteil gemäß Anspruch 1.

Der erfindungsgemäße Bauteil weist eine ausgezeichnete Haftfestigkeit zwischen den Diamantkörnern und der Kupfer-reichen Phase auf.
In Abhängigkeit vom Bor-Gehalt und den Herstellparametern kann man an den Grenzflächen zwischen den Diamantkörnern und der Kupfer-reichen Phase Bor-Anreicherungen im Atomlagenbereich bis hin zur Ausbildung einer Bor-Kohlenstoffverbindung mittels hochauflösender Messverfahren feststellen. Die Dicke der Bor-Kohlenstoffverbindung liegt dabei bevorzugt im Bereich von 1 nm (entsprechend einem Volumengehalt der Bor-Kohlenstoffverbindung von in etwa 0,001 %) bis 10 µm, bevorzugt bis 0,05 µm. Um eine ausreichende Anbindung zu erreichen reicht auch eine nicht vollständige Bedeckung der Diamantkörner aus.
In die Bor-Kohlenstoffverbindung können auch Atome anderer Elemente eingelagert sein.
Bor-Kohlenstoffverbindungen weisen eine ausreichend hohe Wärmeleitfähigkeit auf (z.B. B₄C ca.40 W/(mK)).
Da Bor ein vergleichsweise schwacher Karbidbildner ist, kommt es bei einem Infiltrationsprozess nicht zu einer schnellen Verarmung des karbidbildenden Elements in der Kupferschmelze, wodurch eine hohe Werkstoffhomogenität erreicht werden kann. Zudem sind die sich ausbildenden Karbidschichten vergleichsweise sehr dünn, was sich ebenfalls günstig auf die Wärmeleitfähigkeit auswirkt. Da im festen Zustand die Löslichkeit von Bor in Kupfer sehr gering ist (je nach Abkühlgeschwindigkeit zwischen 0,005 und 0,3 At.%), wird die Wärmeleitfähigkeit der Kupfermatrix nur geringfügig verschlechtert. Bor liegt in ausgeschiedener Form in der Kupfermatrix vor, wobei der Anteil zwischen 0,01 und 20 Vol.% betragen kann. In Abhängigkeit von weiteren Legierungselementen im Kupfer können sich auch borreiche Verbindungen mit einem Borgehalt > 50 At.% ausscheiden. Weitere Gefügebestandteile, wie beispielsweise amorpher Kohlenstoff, verschlechtern die Eigenschaften nicht in einem unzulässigen Ausmaß, solange deren Gehalt 10 Vol.% nicht übersteigt und die Wärmeleitfähigkeit dieser Gefügebestandteile 50 W/(mK) übersteigt. Entscheidend dabei ist immer, dass die Kupfermatrix möglichst frei von Fremdatomen bleibt, bzw. gelöste Anteile die Wärmeleitfähigkeit möglichst geringfügig beeinträchtigen, wie dies bei Cu-Ag oder Cu-Zn der Fall ist.

Die mechanische Bearbeitbarkeit ist auf Grund der sehr duktilen kupferhaltigen Gefügebestandteile in einem ausreichenden Maße gegeben. Für eine kostengünstige Darstellung ist es weiters vorteilhaft, dass durch die hohe Wärmeleitfähigkeit der kupferhaltigen Gefügebestandteile der Diamantgehalt im Vergleich beispielsweise mit Diamant-SiC Werkstoffen reduziert werden kann. Durch Variation des Diamant-, Kupfer und Borgehaltes ist es möglich, in Hinblick auf Wärmeleitfähigkeit und Wärmedehnung maßgeschneiderte Wärmesenken für unterschiedlichste Anforderungen herzustellen.
Besonders vorteilhafte Gehalte an Borkarbid und Kupfer bzw. kupferreicher Phase liegen bei 0,005 bis 1 Vol.% bzw. bei 15 bis 40 Vol.%.
Versuche haben gezeigt, dass Diamantpulver in einem breiten Korngrößenspektrum verarbeitet werden können. Neben Naturdiamanten lassen sich auch preisgünstigere synthetische Diamanten verarbeiten. Es kann daher auf die jeweils kostengünstigste Sorte zurückgegriffen werden kann. Für kostenunkritische Anwendungen mit extrem hohen Anforderungen an die Wärmeleitfähigkeit ist es günstig, eine Diamantfraktion mit einer mittleren Korngröße im Bereich von 50 bis 300 µm, bevorzugt 100 bis 200 µm zu verwenden. Hohe Packungsdichten der Diamantkörner lassen sich durch die Verwendung von Pulvern mit bimodaler Verteilung der Teilchengröße erreichen. Vorteilhaft ist, wenn das erste Verteilungsmaximum bei 20 bis 40 µm und das zweite Verteilungsmaximum bei 130 bis 250 µm liegt.

Für den Einsatz der Bauteile als Wärmesenken für elektronische Komponenten werden diese vorteilhafterweise mit Ni, Cu, Au oder Ag oder einer Legierung dieser Metalle beschichtet und in weiterer Folge mit einem keramischen Rahmen, beispielsweise ais Al₂O₃ oder AlN verlötet.

Für die Herstellung können unterschiedlichste Verfahren eingesetzt werden. So ist es möglich Diamantpulver mit einer Kupfer-Bor Legierung unter Temperatur und Druck zu verdichten. Dies kann beispielsweise in Heißpressen oder heißisostatischen Pressen erfolgen. Grundsätzlich ist es auch möglich, Kupfer und Bor separat einzubringen. In diesem Fall erfolgt die Legierungsbildung während des Heißpressvorganges. Dabei kann auch von B₄C- oder Bor-beschichtetem Diamantpulver ausgegangen werden.
Als besonders vorteilhaft hat sich das Infiltrieren gezeigt. Dabei wird ein Precursor oder Zwischenstoff hergestellt, der neben Diamantpulver auch einen Binder enthalten kann. Besonders vorteilhaft sind dabei Binder, die unter Temperatureinwirkung zu einem hohen Anteil pyrolisieren. Vorteilhafte Bindergehalte liegen bei 1 bis 20 Gew.%. Diamantpulver und Binder werden in üblichen Mischern oder Mühlen vermengt. Danach erfolgt die Formgebung, wobei diese durch Schüttung in eine Form oder druckunterstützt, beispielsweise durch Pressen oder Metallpulverspritzguss, erfolgen kann. In weiterer Folge wird der Zwischenstoff auf eine Temperatur erhitzt, bei der der Binder zumindest teilweise pyrolisiert. Die Pyrolyse des Binders kann jedoch auch während des Aufheizens beim Infiltrationsprozess erfolgen. Der Infiltrationsprozess kann drucklos oder druckunterstützt erfolgen. Letzteres kann durch Squeeze-Casting, Druckguss oder in einer Sinter-HIP Anlage erfolgen. Als Infiltrationsmaterial wird vorteilhafterweise eine Folie aus einer Kupfer-Bor Legierung mit einem Borgehalt von 1 bis 4 Gew.% verwendet. Es ist auch hier möglich, dass die Legierungsbildung in-situ während des Infiltrationsprozesses erfolgt. Für die Wahl der Zusammensetzung ist zu berücksichtigen, dass die Liquidustemperatur der jeweiligen Legierung nicht höher als 1200°C, vorteilhafterweise nicht höher als 1050°C liegt, da sich ansonsten zu hohe Diamantanteile zersetzen. Besonders gut für das Infiltrieren eignen sich Folien mit einer eutektischen oder nahe-eutektisch Zusammensetzung, wobei nahe-eutektische Zusammensetzungen Legierungen umfassen, deren Liquidustemperatur < 1050°C beträgt. Neben der besonders vorteilhaften Verwendung der Bauteile für die Wärmeableitung bei Halbleiterkomponenten kann der erfindungsgemäße Verbundwerkstoff auch als Wärmesenke in anderen Anwendungsbereichen wie beispielsweise im Bereich der Luft- und Raumfahrt oder Motorenbau eingesetzt werden.
Im Folgenden wird die Erfindung durch Herstellbeispiele näher erläutert.

### Beispiel 1

Diamantpulver der Größe 90 - 104 µm (Mesh 140 - 170) wurde in einen Aluminiumoxid-Tiegel gefüllt und durch Rütteln verdichtet. Auf die Diamantschüttung wurde ein zylindrisches Stück einer nahe-eutektischen Cu - 2,5 Gew.% Bor Legierung gelegt. Der mit Diamant und Legierung bestückte Tiegel wurde in einen durch Induktion beheizbaren zylindrischen Raum innerhalb eines Druckbehälters gestellt. Nachdem ein primäres Vakuum erreicht worden war, wurde die Charge auf 1080°C geheizt und bei der Endtemperatur während 15 Minuten belassen. Anschließend wurde ein Gasdruck von 50 bar im Druckbehälter eingestellt und die Heizung abgestellt. Der aus diesem Vorgang resultierende Cu-B-Diamant-Verbundwerkstoff hatte eine thermische Leitfähigkeit von 540 W/(mK), gepaart mit einem thermischen Ausdehnungskoeffizienten von 6,6 x 10⁻⁶ K⁻¹.

### Beispiel 2

Diamantpulver der Größe 180 - 215 (Mesh 70 - 80) wurde wie in Beispiel 1 erwähnt mit einer nahe-eutektischen Cu - 2,5 Gew.% B Legierung infiltriert, diesmal allerdings mit lediglich 5 bar Gasdruck. Der aus diesem Vorgang resultierende Cu-B-Diamant-Verbundwerkstoff hatte eine thermische Leitfähigkeit von 620 W/(mK), gepaart mit einem thermischen Ausdehnungskoeffizienten von 6,9 x 10⁻⁶ K⁻¹.

## Patentansprüche

1. Bauteil als Wärmesenke aus einem Verbundwerkstoff, bestehend aus 40 bis 90 Vol.% Diamantkörnern, 7 bis 59 Vol.% Kupfer oder einem kupferreichen Mischkristall mit Cu > 80 At.%, 0,01 bis 20 Vol.% Bor oder einer borreichen Phase, mit B > 50 At.% und wahlweise aus einem oder mehreren Gefügebestandteilen der Gruppe Bor-Kohlenstoff-Verbindung, silberreiche Phase, amorpher Kohlenstoff, wobei der Gehalt für die Bor-Kohlenstoff-Verbindung 0,001 bis 5 Vol.%, für die silberreiche Phase 0,01 bis 10 Vol.% und für den amorphen Kohlenstoff 0,01 bis 5 Vol.% beträgt.

2. Bauteil nach Anspruch 1, **dadurch gekennzeichnet, dass** der kupferreiche Mischkristall 0,005 bis 0,3 At.% Bor enthält.

3. Bauteil nach Anspruch 1 oder 2, **dadurch gekennzeichnet, dass** die Bor-Kohlenstoff-Verbindung überwiegend oder ausschließlich durch Umsetzung von Bor mit dem Kohlenstoff des Diamants gebildet ist.

4. Bauteil nach Anspruch 3, **dadurch gekennzeichnet, dass** die Bor-Kohlenstoff-Verbindung als Schicht vorliegt, die die Oberfläche der Diamantkörner zumindest zu 60 % bedeckt.

5. Bauteil nach Anspruch 4, **dadurch gekennzeichnet, dass** die Dicke der Bor-Kohlenstoff-Schicht 1 bis 50 nm beträgt.

6. Bauteil nach einem der vorhergehenden Ansprüche, **dadurch gekennzeichnet, dass** der Kupfer-Mischkristall 0,01 bis 5 At.% Silber enthält.

7. Bauteil nach einem der vorhergehenden Ansprüche, **dadurch gekennzeichnet, dass** die mittlere Diamantkorngröße 50 bis 300 µm beträgt.

8. Bauteil nach Anspruch 7, **dadurch gekennzeichnet, dass** die mittlere Diamantkorngröße 100 bis 200 µm beträgt.

9. Bauteil nach einem der Ansprüche 1 bis 6, **dadurch gekennzeichnet, dass** die Diamantkorngröße bimodal verteilt ist, mit einem ersten Verteilungsmaximum bei 20 bis 40 µm und einem zweiten Verteilungsmaximum bei 130 bis 250 µm.

10. Bauteil nach einem der vorhergehenden Ansprüche, **dadurch gekennzeichnet, dass** der Verbundwerkstoff 0,005 bis 1 Vol.% einer Bor-Kohlenstoffverbindung enthält.

11. Bauteil nach einem der vorhergehenden Ansprüche, **dadurch gekennzeichnet, dass** der Verbundwerkstoff 15 bis 40 Vol.% Kupfer oder einen kupferreichen Mischkristall mit Cu > 90 At.% enthält.

12. Bauteil nach einem der vorhergehenden Ansprüche, **dadurch gekennzeichnet, dass** der Verbundwerkstoff 0,2 bis 10 Vol.% Bor oder eine borreiche Phase mit B > 90 At.% enthält.

13. Bauteil nach einem der vorhergehenden Ansprüche, **dadurch gekennzeichnet, dass** auf diesem ein metallischer Überzug aufgebracht ist, der aus Ni, Cu, Au, Ag oder einer Legierung dieser Metalle besteht.

14. Bauteil nach einem der vorhergehenden Ansprüche, **dadurch gekennzeichnet, dass** auf diesem ein keramischer Rahmen aufgelötet ist.

15. Verfahren zur Herstellung eines Bauteils nach einem der vorhergehenden Ansprüche, **dadurch gekennzeichnet, dass** das Verfahren zumindest folgende Prozessschritte umfasst:
- Drucklose oder druckunterstützte Formgebung eines Zwischenstoffes, der Diamantkömer mit einer mittleren Korngröße von 100 bis 300 µm und optional eine Cu-B Legierung und/oder Binder enthält, wobei der Diamantanteil bezogen auf das Gesamtvolumen des Zwischenstoffes nach dem Formgebungsschritt 40 bis 90 % beträgt;
- Druckloses oder druckunterstütztes Erhitzen des Zwischenstoffes und einer Cu- und B-haltigen Infiltratlegierung auf eine Temperatur über der Liquidustemperatur der Cu- und B-haltigen Infiltratlegierung, jedoch unter 1100°C, wobei es zu einer Infiltration des Zwischenstoffes durch die Infiltratlegierung kommt und die Porenräume des Zwischenstoffes zumindest zu 97% gefüllt werden.

16. Verfahren zur Herstellung eines Bauteils nach einem der Ansprüche 1 bis 14, **dadurch gekennzeichnet, dass** das Verfahren zumindest folgende Prozessschritte umfasst:
- Mischen oder Mahlen eines Zwischenstoffes, der zumindest aus Diamantkörnern und einer Cu- und B-haltigen Infiltratlegierung besteht;
- Füllen einer Matrize einer Heißpresse mit dem Zwischenstoff, Erhitzen auf eine Temperatur T, mit 500°C < T < 1100°C und Heißpressen des Zwischenstoffes.

17. Verfahren nach Anspruch 15 oder 16, **dadurch gekennzeichnet, dass** zur Infiltration eine eutektische oder nahe-eutektische Cu-B-Legierung zur Verwendung kommt, wobei nahe-eutektische Legierungen solche umfassen, deren Liquidustemperatur < 1050°C beträgt.

18. Verwendung eines Bauteils nach einem der Ansprüche 1 bis 14 als Wärmesenke für Halbleiterkomponenten.

## Claims

1. Component as a heat sink made from a composite material consisting of 40 to 90 vol.% of diamond grains, 7 to 59 vol.% of copper or a copper-rich mixed crystal with Cu > 80 at.%, 0.01 to 20 vol.% of boron or a boron-rich phase with B > 50 at.%, and optionally one or more structural constituents from the group comprising boron-carbon compound, silver-rich phase, amorphous carbon, wherein the content for the boron-carbon compound is 0.001 to 5 vol.%, that for the silver-rich phase is 0.01 to 10 vol.% and that for the amorphous carbon is 0.01 to 5 vol.%.

2. Component according to claim 1, **characterised in that** the copper-rich mixed crystal contains 0.005 to 0.3 at.% of boron.

3. Component according to claim 1 or 2, **characterised in that** the boron-carbon compound is formed predominantly or exclusively by reaction of boron with the carbon of the diamond.

4. Component according to claim 3, **characterised in that** the boron-carbon compound is present as a layer which covers at least 60% of the surface of the diamond grains.

5. Component according to claim 4, **characterised in that** the thickness of the boron-carbon layer is 1 to 50 nm.

6. Component according to one of the preceding claims, **characterised in that** the copper mixed crystal contains 0.01 to 5 at.% of silver.

7. Component according to one of the preceding claims, **characterised in that** the average diamond grain size is 50 to 300 µm.

8. Component according to claim 7, **characterised in that** the average diamond grain size is 100 to 200 µm.

9. Component according to one of claims 1 to 6, **characterised in that** the diamond grain size is bimodally distributed, with a first distribution maximum at 20 to 40 µm and a second distribution maximum at 130 to 250 µm.

10. Component according to one of the preceding claims, **characterised in that** the composite material contains 0.005 to 1 vol.% of a boron-carbon compound.

11. Component according to one of the preceding claims, **characterised in that** the composite material contains 15 to 40 vol.% of copper or a copper-rich mixed crystal with Cu > 90 at.%.

12. Component according to one of the preceding claims, **characterised in that** the composite material contains 0.2 to 10 vol.% of boron or a boron-rich phase with B > 90 at.%.

13. Component according to one of the preceding claims, **characterised in that** a metallic coating consisting of Ni, Cu, Au, Ag or an alloy of said metals is applied thereto.

14. Component according to one of the preceding claims, **characterised in that** a ceramic frame is soldered thereto.

15. Process for producing a component according to one of the preceding claims, **characterised in that** the process comprises at least the following process steps:
- Unpressurised or pressure-assisted moulding of an intermediate containing diamond grains having an average grain size of 100 to 300 µm and optionally a Cu-B alloy and/or binders, wherein the proportion of diamond based on the total volume of the intermediate after the moulding step is 40 to 90%;
- Unpressurised or pressure-assisted heating of the intermediate and a Cu- and B-containing infiltration alloy to a temperature above the liquidus temperature of the Cu- and B-containing infiltration alloy but below 1100°C, wherein the intermediate is infiltrated by the infiltration alloy and the pore spaces of the intermediate are filled to at least 97%.

16. Process for producing a component according to one of claims 1 to 14, **characterised in that** the process comprises at least the following process steps:
- Mixing or grinding an intermediate consisting at least of diamond grains and a Cu-.and B-containing infiltration alloy;
- Filling a female mould in a hot press with the intermediate, heating to a temperature T, where 500°C < T < 1100°C, and hot press moulding the intermediate.

17. Process according to claim 15 or 16, **characterised in that** a eutectic or near-eutectic Cu-B alloy is used for infiltration, wherein near-eutectic alloys include those whose liquidus temperature is < 1050°C.

18. Use of a component according to one of claims 1 to 14 as a heat sink for semiconductor components.

## Revendications

1. Composant utilisé comme dissipateur thermique constitué d'une matière composite contenant des teneurs volumiques de 40 à 90% de grains de diamant, de 7 à 59% de cuivre ou d'une solution solide riche en cuivre à teneur atomique en cuivre > 80%, de 0,01 à 20% de bore ou d'une phase riche en bore à teneur atomique en B > 50%, et facultativement un ou plusieurs constituants de texture sélectionnés dans le groupe formé par une combinaison carbone-bore, une phase riche en argent ou du carbone amorphe, où les teneurs volumiques sont respectivement de 0,001 à 5% pour la combinaison carbone-bore, de 0,01 à 10% pour la phase riche en argent et de 0,01 à 5% pour le carbone amorphe.

2. Composant selon la revendication 1, **caractérisé en ce que** la teneur atomique en bore dans la solution solide riche en cuivre est de 0,005 à 0,3%.

3. Composant selon la revendication 1 ou 2, **caractérisé en ce que** la combinaison carbone-bore est formée de façon prépondérante ou exclusive par substituant de bore avec le carbone du diamant.

4. Composant selon la revendication 3, **caractérisé en ce que** la combinaison carbone-bore forme une couche, qui recouvre au moins 60% de la surface des grains de diamant.

5. Composant selon la revendication 4, **caractérisé en ce que** l'épaisseur de la couche de carbone-bore est d'au moins 1 à 50 nm.

6. Composant selon l'une quelconque des revendications précédentes, **caractérisé en ce que** la solution solide de cuivre contient une teneur atomique de 0,01 à 5% d'argent.

7. Composant selon l'une quelconque des revendications précédentes, **caractérisé en ce que** la granulométrie moyenne du diamant est de 50 à 300 µm.

8. Composant selon la revendication 7, **caractérisé en ce que** la granulométrie moyenne du diamant est de 100 à 200 µm.

9. Composant selon l'une quelconque des revendications 1 à 6, **caractérisé en ce que** la granulométrie du diamant est répartie d'une façon bimodale dans laquelle un premier maximum de répartition est entre 20 et 40 µm et un deuxième maximum de répartition est entre 130 et 250 µm.

10. Composant selon l'une quelconque des revendications précédentes, **caractérisé en ce que** la matière composite contient une teneur volumique de 0,005 à 1 % d'une combinaison carbone-bore.

11. Composant selon l'une quelconque des revendications précédentes, **caractérisé en ce que** la matière composite contient une teneur volumique de 15 à 40% de cuivre ou une solution solide riche en cuivre à teneur atomique en cuivre > 90%.

12. Composant selon l'une quelconque des revendications précédentes, **caractérisé en ce que** la matière composite contient une teneur volumique de 0,2 à 10% de bore ou une phase riche en bore à teneur atomique en B > 90%.

13. Composant selon l'une quelconque des revendications précédentes, **caractérisé en ce qu'**un revêtement métallique, qui se compose de Ni, Cu, Au, Ag ou d'un alliage de ces métaux, y est appliqué.

14. Composant selon l'une quelconque des revendications précédentes, **caractérisé en ce qu'**un cadre céramique y est brasé.

15. Procédé de fabrication d'un composant selon l'une quelconque des revendications précédentes, **caractérisé en ce que** le procédé comprend au moins les étapes suivantes de processus:
- former sans pression ou sous pression une matière intermédiaire qui contient des grains de diamant d'une granulométrie moyenne de 100 à 300 µm et facultativement un alliage Cu-B et/ou des liants, dans laquelle la teneur en diamant s'élève à 40 à 90% du volume total de la matière intermédiaire après l'étape de formage;
- chauffer sans pression ou sous pression la matière intermédiaire et un alliage d'infiltrat, à teneurs en Cu et en B, à une température supérieure à la température de liquidus de l'alliage d'infiltrat à teneurs en Cu et B, mais inférieure à 1100°C, ce qui provoque une infiltration de l'alliage d'infiltrat dans la matière intermédiaire, et un remplissage des espaces poreux de la matière intermédiaire au moins à 97%.

16. Procédé de fabrication d'un composant selon l'une quelconque des revendications 1 à 14, **caractérisé en ce que** le procédé comprend au moins les étapes suivantes de processus:
- mélanger ou broyer une matière intermédiaire qui contient au moins des grains de diamant et d'un alliage d'infiltrat à teneurs en Cu et B;
- remplir de la matière composite une matrice d'une presse à haute température, chauffer à une température T, où 500°C < T < 1100°C, et comprimer la matière intermédiaire à haute température.

17. Procédé selon la revendication 15 ou 16, **caractérisé en ce qu'**un alliage eutectique, ou voisin de l'eutectique, de Cu-B est utilisé pour l'infiltration, des alliages voisins de l'eutectique comprenant des alliages dont la température de liquidus est < 1050°C.

18. Utilisation d'un composant selon l'une quelconque des revendications 1 à 14 comme dissipateur thermique pour des composants semi-conducteurs.
